# EUROPEAN PATENT SPECIFICATION

(11) **EP 0 595 300 B1**
(45) Date of publication and mention of the grant of the patent: **07.02.1996**
(21) Application number: 93117421.3
(22) Date of filing: 27.10.1993
(51) Int. Cl.: H01L 21/00

(54) **Apparatus for manufacturing semiconductor device**
Apparat für die Herstellung von Halbleiter-Einrichtungen
Appareil pour fabriquer des dispositifs semi-conducteur

(30) Priority: 27.10.1992 JP 288603/92
(43) Date of publication of application: 04.05.1994
(73) Proprietor: SEMICONDUCTOR PROCESS LABORATORY CO., LTD., Minato-ku, Tokyo 108 (JP); ALCAN- TECH CO., INC., Tokyo (JP); CANON SALES CO., INC., Minato-ku, Tokyo 108 (JP)
(72) Inventor: Maeda, Kazuo, c/o Semiconductor Process Lab., Tokyo (JP); Ohira, Kouichi, c/o Semiconductor Process Lab., Tokyo (JP); Chino, Hiroshi, c/o Semiconductor Process Lab., Tokyo (JP); Maloney, James, San Jose, CA 94038 (US); Knowles, James, Moss Beach, CA 94038 (US); Nelson, John, San Jose, CA 95129 (US)
(74) Representative: Marx, Lothar, Dr.

(56) References cited:
- EP-A- 0 319 121
- EP-A- 0 399 616
- EP-A- 0 467 624
- EP-A- 0 532 758

## Description

### BACKGROUND OF THE INVENTION

### 1. Field of the Invention

The present invention relates to an apparatus for manufacturing a semiconductor device, according to the preamble of claim 1.

### 2. Field of the Related Art

The CVD apparatus for mass production includes the following types.
(1) Batch process CVD apparatus
(2) Continuous CVD apparatus
   (a) Conveyer type
   (b) Walking beam type
(3) Multi-chamber CVD apparatus

Though the above batch process CVD apparatus has a high mass productivity, it cannot correspond to the increase of wafer diameter or it is not suitable for accurate production control. Moreover, the throughput does not always increase because the treatment speed is low.

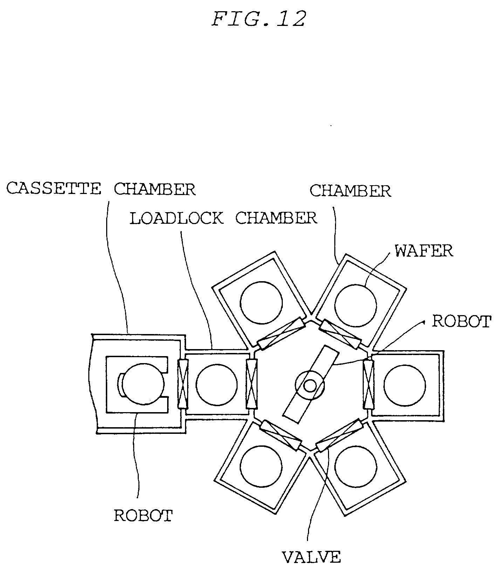

The multi-chamber CVD apparatus mainly used for forming a film under a low pressure shown in Fig. 12 performs various types of treatments and has a high flexibility because each chamber is independently formed. However, the throughput is considerably low.Therefore, to correspond to the increase of wafer diameter or realize a high throughput, the continuous CVD apparatus is originally advantageous.

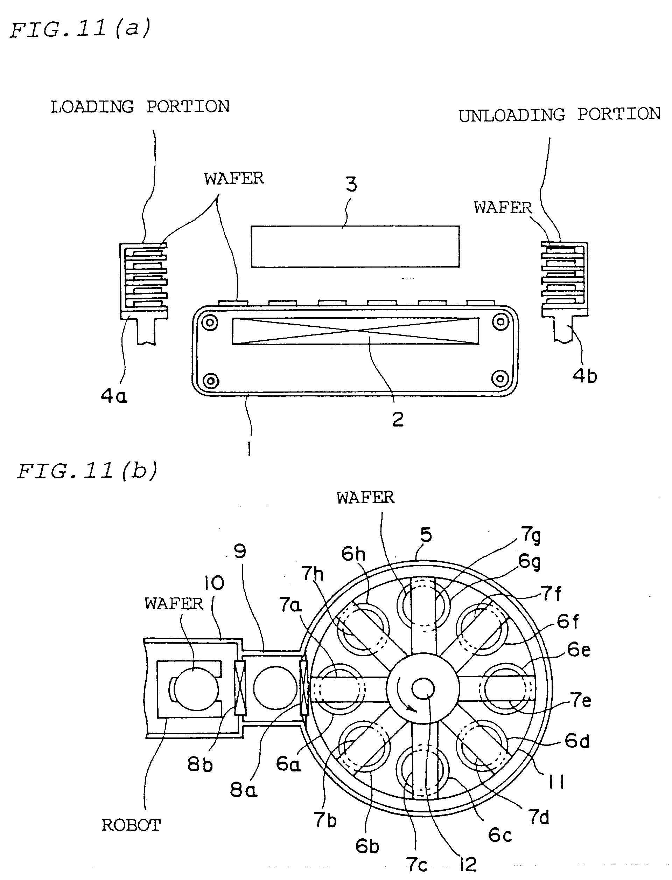

Fig. 11 (a) shows a conveyer-type continuous CVD apparatus which is mainly used to form a film under the normal pressure. Symbol 1 is a conveyer belt and 2 is a heater secured under the conveyer belt 1 separately from the belt 1. Symbol 3 is a gas distributor provided above the conveyer belt 1, 4a is a cassette station of a wafer loading portion, and 4b is a cassette station of a wafer unloading portion. Wafers are mounted on the conveyer belt 1 and sent in order, and indirectly radiant-heated by heater 2 provided under the conveyer belt 1.

Fig. 11 (b) shows a walking-beam-type continuous CVD apparatus which is mainly used to form a film through plasma CVD under a low pressure. Symbol 5 is a chamber and symbols 6a to 6h are susceptors having a heater respectively which are secured to a base 11. Symbols 7a to 7h are eight walking beams rotatable around a rotary shaft 12 by holding wafers and 8a and 8b are gate valves. Symbol 9 is a load-lock chamber connected to the chamber 5 through the gate valve 8a and 10 is a cassette chamber connected to the load-lock chamber 9 through the gate valve 8b.

A film is formed by using the apparatus as shown below. First, a wafer is moved from the load-lock chamber 9 onto the susceptor 6a in the chamber 5 and thereafter it is heated up to a predetermined temperature by a heater under the susceptor 6a.

Then, a film is formed on the wafer on the susceptor 6a and thereafter the wafer is moved to the susceptor 6b by the walking beam 7a to form the next film. At the same time, the next wafer is moved from the load-lock chamber 9 onto the susceptor 6a in the chamber 5 and heated up to a predetermined temperature by a heater under the susceptor 6a. According to the above procedure, a film is formed on the wafer on the susceptors 6a and 6b.

Thus, wafers are introduced into the chamber 5 one by one to continuously form films on wafers while moving them onto the susceptors 6a to 6h in order. Therefore, by passing a wafer through the susceptors 6a to 6h once, it is possible to form different types of multilayer films or single-layer films with a predetermined thickness on the wafer.
(1) However, the conveyer-type CVD apparatus has problems that it is difficult to accurately measure the wafer temperature because a wafer moves on the secured heater 2 and it is impossible to accurately control the wafer temperature because the heater 2 is to some extent separate from the conveyer belt 1.
(2) Also for the walking-beam-type CVD apparatus, it cannot be avoided that the wafer temperature lowers because a wafer separates from the heater under the susceptors 6a to 6h. Therefore, the CVD apparatus has a problem that strain is left in a formed film because a temperature cycle is given during film forming. Moreover, the apparatus has another problem that a lot of time is required to stabilize the wafer temperature and temperature adjustment is complex because it is necessary to reheat a wafer to keep the wafer temperature at a predetermined value when moving the wafer from the susceptor 6a to the next susceptor 6b.

To solve these problems, it is considered to secure a wafer holder to a heater and move a gas distributor. However, there is a problem that wafers cannot be continuously treated because they do not move.

An apparatus as defined in the pre-characterizing portion of claim 1 is known from EP-A- 532 758 corresponding to WO 92/15 114. In this apparatus the heating instrument is barried in the wafer loading table and both the wafer Coating table and the heating instrument are made to rotate around the rotary sheft. Therefore it is difficult to apply electric wiving to the rotating heating instrument.

### SUMMARY OF THE INVENTION

It is an object of the present invention to provide an apparatus for manufacturing a semiconductor device with electric wiving which can be easily applied capable of moving wafers while keeping the wafer temperature at a predetermined value, accurately production-controlling each wafer, and quickly forming a multilayer film.

This object is solved by the features of claim 1.

For the semiconductor device manufacturing apparatus of the present invention, a wafer holder, gas distributor, and heating instrument are separated from each other, and the wafer holder is supported with a rotary shaft so that it rotates around the rotary shaft on a plane put between the gas distributor and heating instrument. Therefore, films can be formed continuously or intermittently and a high throughput can be maintained.

Moreover, because the wafer holder is separate from the heating instrument, electric wiring can be easily applied to the fixed heating instrument, and therefore the apparatus structure is simplified and the apparatus is easily maintained.

Furthermore, because wafers are moved in state of being held by the wafer holder with a large heat capacity, it is possible to prevent wafers from cooling down while they are moved. Thereby, the wafer temperature is kept constant and the temperature stability is improved. Therefore, it is possible to form a uniform-thickness and high-quality film on a wafer.

Moreover, by separately installing a plurality of wafer-holder susceptors and a plurality of gas-distributor dischargers, production of each wafer can be accurately controlled and different types of multilayer films can be quickly formed.

Furthermore, because means for making a susceptor perform reciprocative arc motion along the circumference around a rotary shaft or reciprocative linear motion in the radial direction of a circle around the rotary shaft or means for making a plurality of susceptors perform reciprocative arc motion around an axis vertical to the wafer mounting surface at the position where each susceptor is held or reciprocative linear motion in the radial direction of the circle around the axis is used, reaction gas is uniformly supplied to wafers. Thereby, it is possible to form uniform-thickness and high-quality films on wafers.

### BRIEF DESCRIPTION OF THE DRAWINGS

Fig. 1 is a side view for explaining the CVD apparatus of the first embodiment of the present invention;
Fig. 2 is a bottom view for explaining a wafer holder of the CVD apparatus of the first embodiment of the present invention;
Fig. 3 is a top view for explaining details of a gas distributor of the CVD apparatus of the first embodiment of the present invention;
Fig. 4 is a top view for explaining details of a mechanical portion for setting or detaching a wafer to or from the CVD apparatus of the first embodiment of the present invention;
Fig. 5 is a side view for explaining a method for setting or detaching a susceptor to or from a wafer holder of the CVD apparatus of the first embodiment of the present invention;
Fig. 6 is a side view for explaining a method for cleaning a gas distributor of the CVD apparatus of the first embodiment of the present invention;
Fig. 7 is a perspective view for explaining a gas distributor, wafer holder, and heater of the second embodiment of the present invention;
Figs. 8 (a) to 8 (d) are perspective views for explaining the approximate constitution of gas distributors, wafer holders, and heaters of the first to fourth embodiments of the present invention;
Figs. 9 (a) to 9 (d) are perspective views for explaining the approximate constitution of gas distributors, wafer holders, and heaters of the fifth to eighth embodiments of the present invention;
Figs. 10 (a) to 10 (c) are illustrations for explaining a semiconductor device manufacturing method using the CVD apparatus of the first embodiment of the present invention; and
Figs. 11 (a) and 11 (b) are illustrations for explaining a CVD apparatus according to the related art; and
Fig. 12 is an illustration for explaining a CVD apparatus according to the related art.

### DESCRIPTION OF THE PREFERRED EMBODIMENTS

Embodiments of the present invention are described below by referring to drawings.

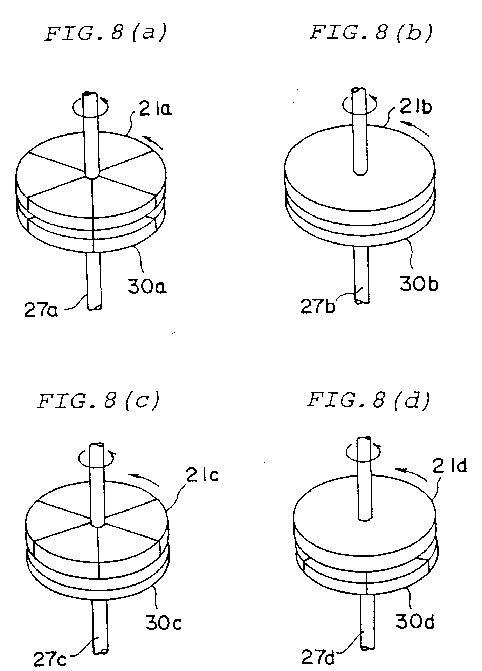

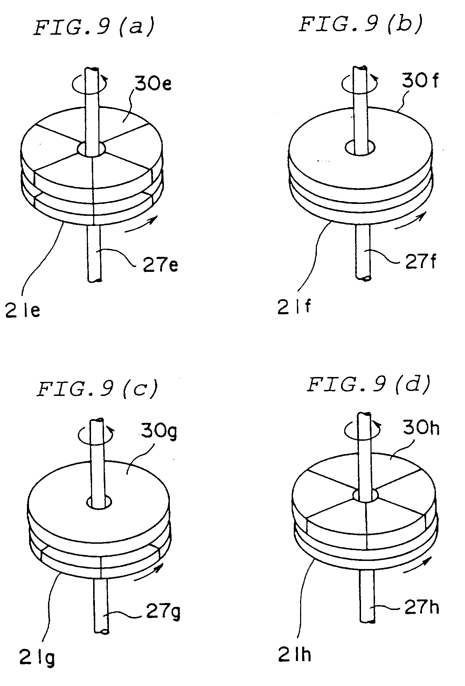

Figs. 8 (a) to 8 (d) and Figs. 9 (a) to 9 (d) are schematic perspective views showing the basic constitution of CVD apparatuses of first to eighth embodiments of the present invention. In these figures, symbols 21a to 21h are wafer holders and 30a to 30h are gas distributors. Though heaters (heating means) are not illustrated, wafer holders are provided between the heaters and gas distributors. Heaters are separated so that they correspond to separated susceptors (wafer mounting tables) or they are formed on the entire surface without being separated. They are shown below by corresponding to drawings.
(a) CVD apparatus having a downward wafer mounting surface
   (1) Discrete gas distributor 30a and discrete wafer holder 21a of first embodiment {Fig. 8 (a)}
   (2) One-body gas distributor 30b and one-body wafer holder 21b of second embodiment {Fig. 8 (b)}
   (3) One-body gas distributor 30d and discrete wafer holder 21c of third embodiment {Fig. 8 (c)}
   (4) Discrete gas distributor 30d and one-body wafer holder 21d of fourth embodiment {Fig. 8 (d)}
(b) CVD apparatus having an upward wafer mounting surface
   (1) Discrete gas distributor 30e and discrete wafer holder 21e of fifth embodiment {Fig. 9 (a)}
   (2) One-body gas distributor 30f and one-body wafer holder 21f of sixth embodiment {Fig. 9 (b)}
   (3) One-body gas distributor 30g and discrete wafer holder 21g of seventh embodiment {Fig. 9 (c)}
   (4) Discrete gas distributor 30h and one-body wafer holder 21h of eighth embodiment {Fig. 9 (d)}

The following is the description of the above CVD apparatuses comprising various combinations of a gas distributor with a wafer holder.

### (1) First to fifth embodiments

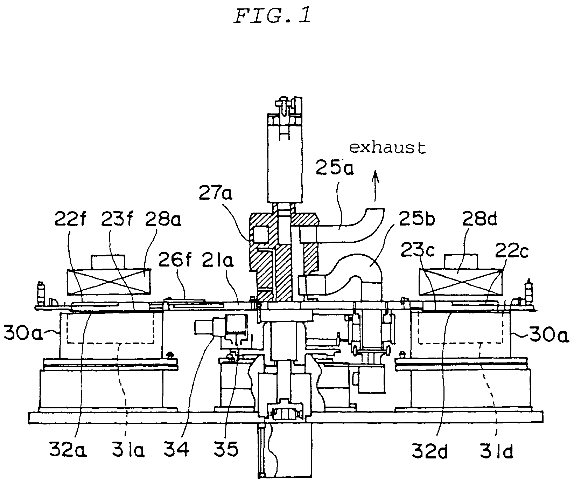

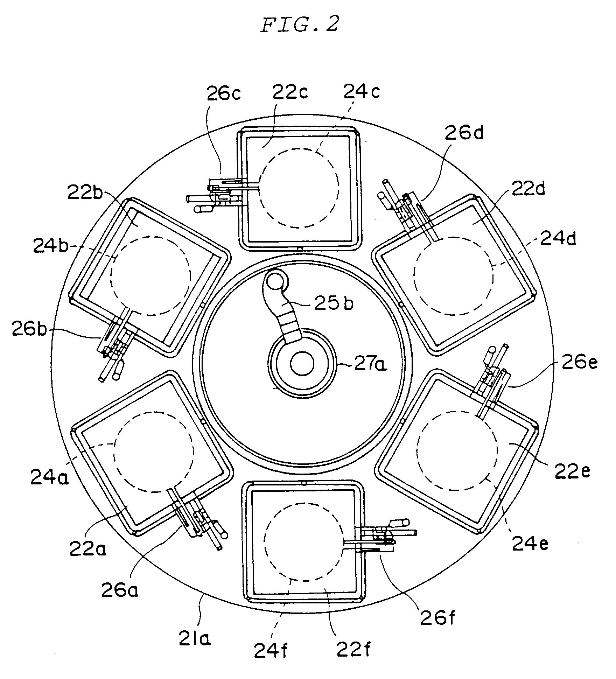

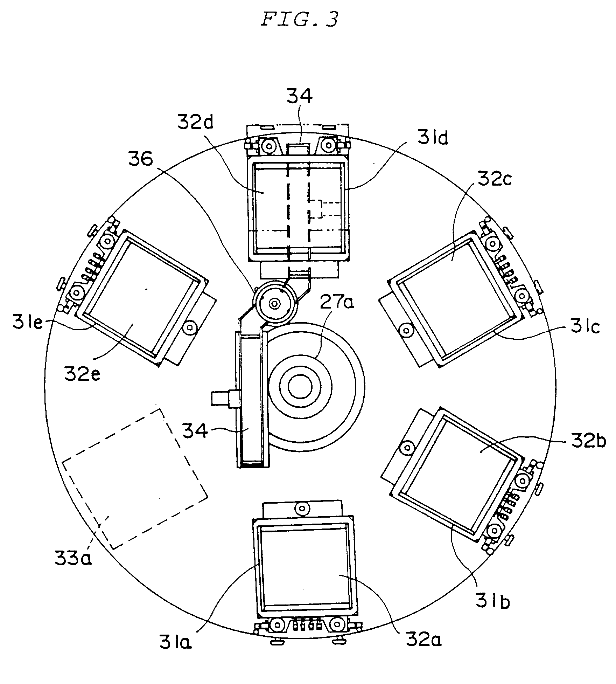

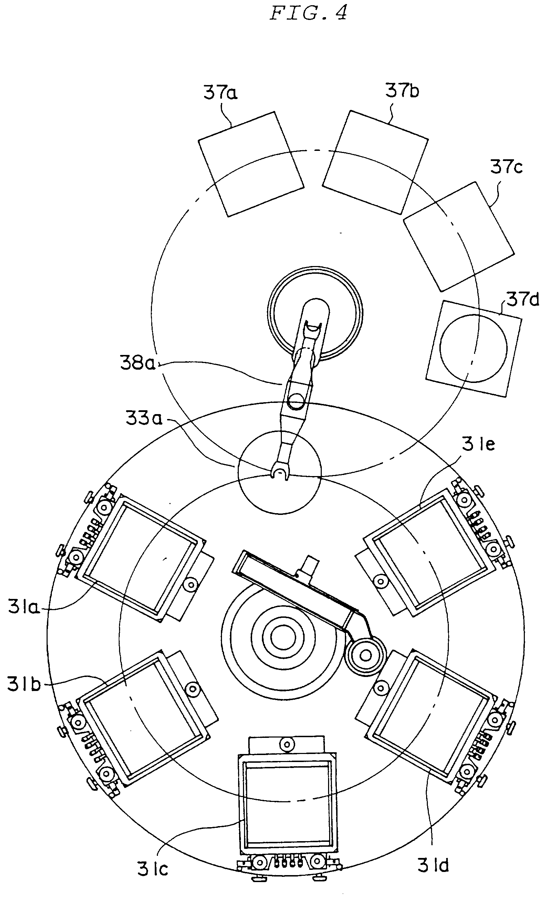

Figs. 1 to 4 are illustrations for explaining the entire constitution of the CVD apparatus of the first embodiment of the present invention corresponding to Fig. 8 (a), in which Fig. 1 is a side view, Fig. 2 is a detailed top view of a wafer holder supported with a rotary shaft, Fig. 3 is a detailed top view of a gas secured separately from the rotary shaft, and Fig. 4 is a detailed top view of a mechanical portion for loading or unloading a wafer on or from a wafer holder by a robot.

### (A) Constitution of CVD apparatus

Figs. 1 and 2, symbol 21a is a discoid wafer holder on which six detachable susceptors (wafer mounting table) 22a to 22f are set. The susceptors 22a to 22f are made of stainless steel, having a large heat capacity so that the temperature raised by a heater does not rapidly lower. The wafer mounting surfaces 23a to 23f of the susceptors 22a to 22f are turned downward and the wafers 24a to 24f are mounted on the wafer mounting surfaces 23a to 23f so that the surfaces to be deposited face downward. An exhaust port or a gas introduction port 25a is connected to the wafer holder 21a through a pipe 25b to secure the mounted wafers 24a to 24f by a vacuum chuck or remove the secured wafers by blowout of nitrogen gas.

Moreover, the susceptors 22a to 22f are provided with an oscillation unit respectively, which perform reciprocative arc motion around an axis vertical to each of the wafer mounting surfaces 23a to 23f or reciprocative linear motion in the radial direction of a circle around the axis. Symbols 26a to 26f are temperature measuring means for measuring the temperature of the wafers set to the susceptors 22a to 22f, which use thermocouples. Symbol 27a is a rotary shaft supporting the wafer holder 21a which rotates in the circumferential direction around the rotary shaft 27a.

Symbols 28a to 28f are heaters (heating means) provided above the wafer holder 21a, which are separated from others so that an electric power can be independently supplied to each of them. The heaters 28a to 28f supply energy to the susceptors 22a to 22f by means of heat radiation or heat conduction from the back side different from the wafer mounting surfaces 23a to 23f to heat the susceptors and indirectly heats the wafers 24a to 24f by raising the temperature of the susceptors 22a to 22f.

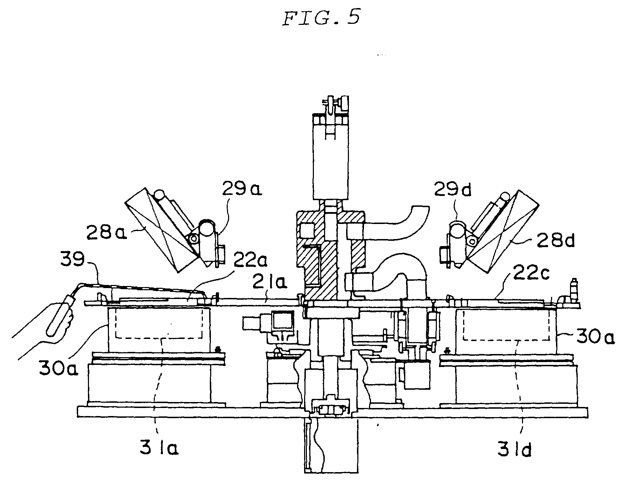

However, Fig. 1 shows only the heaters 28a and 28d among heaters 28a to 28f. Moreover, each of the heaters 28a to 28f is turned upward around each of the rotary axes 29a to 29f so that a space can be secured above each of the the susceptors 22a to 22f, and each of the susceptors 22a to 22f can be detached. However, Fig. 5 shows only the rotary axes 29a and 29d among the rotary axes 29a to 29f.

In Figs. 1 and 3, symbol 30a is a gas distributor for supplying reaction gas to wafers, on which gas dischargers 31a to 31e are provided at five places one each and the loading/unloading portion 33a settles at one place so that they face the susceptors 22a to 22f. The gas discharge surfaces 32a to 32e of the gas dischargers 31a to 31e are turned upward to face the susceptors 22a to 22f. And, from the peripheral portions of the gas dischargers 31a to 31e unnecessary gas discharged from the gas dischargers 31a to 31e is exhausted .

Symbol 34 is a cleaner for detaching reaction products from the gas discharge surfaces 32a to 32e, which moves together with the rotary shaft 36 and wafer holder 21a and is normally stored in the vicinity of the rotary shaft 27a of the wafer holder 21a. To clean the gas discharge surfaces 32a to 32e, the cleaner 34 moves onto the gas discharge surfaces 32a to 32e to remove deposits from the gas discharge surfaces 32a to 32e with a brush 35. In this case, the cleaner 34 sucks the detached deposits by means of vacuum evacuation.

In Fig. 4, symbols 37a are wafer storing portions for storing wafers before films are formed, symbol 37b is a wafer storing portion for storing wafers after films are formed and 37c is a cooling portion for cooling wafers immediately after films are formed with nitrogen gas or the like. Symbol 37d is a spare portion for storing wafers overflown from the wafer storing portion 37a or 37b. Symbol 38a is a robot for transferring wafers from the wafer storing portion 37a to the wafer holder 21a or from the wafer holder 21a to the wafer storing portion 37b.

In Fig. 4, objects provided with symbols same as those in Figs. 2 and 3 show the same objects as those in Figs. 2 and 3.

### (B) Susceptor setting/detaching method

Fig. 5 is a side view for explaining a method for setting/detaching the susceptors 22a to 22f to or from the wafer holder 21a. Setting or detaching of the susceptors 22a to 22f is necessary in case of setting temperature-measuring thermocouples or replacing the susceptors with new ones. To set or detach the susceptors 22a to 22f to or from the wafer holder 21a, it is first necessary to move the heaters 28a to 28f provided closely to the susceptors 22a to 22f so that the heaters do not interrupt setting or detaching of the susceptors. In this case, the heaters 28a to 28f can be turned upward or downward around the rotary axes 29a to 29f parallel with the gas discharge surfaces 32a to 32e. Therefore, as shown in Fig. 5, the heaters 28a to 28f above the susceptors 22a to 22f are turned upward to secure a space on the susceptors 22a to 22f. Then, the wafer holder 21a is set or detached by hand or by using a setting/detaching tool 39.

After the susceptors 22a to 22f are set or detached, the heaters 28a to 28f are turned downward again so that they face the gas discharge surfaces 32a to 32e of the gas distributors 30a to 30e.

As described above, the susceptors 22a to 22f can be easily set or detached by turning the heaters 28a to 28f upward or downward around the rotary axes 29a to 29f. Moreover, because the heaters 28a to 28f rotate around the fixed rotary axes 29a to 29f, they can be set to a certain position above the susceptors 22a to 22f. Thereby, radiant heat and conduction heat can be effectively transferred from the heaters 28a to 28f to the susceptors. Thus, it is possible to accurately set the susceptor temperature and wafer temperature.

### (C) Gas discharger cleaning method

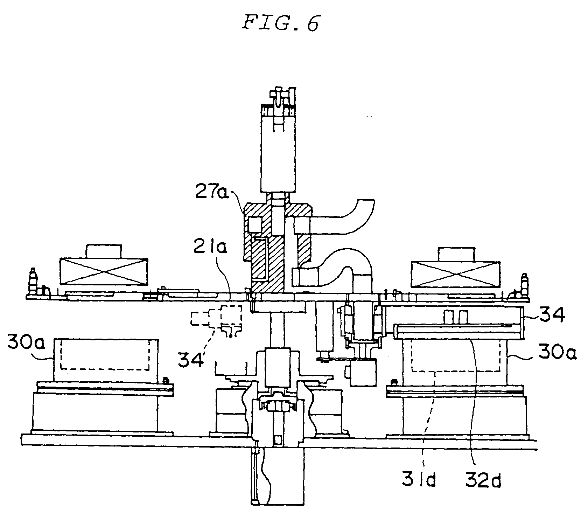

Figs. 3 and 6 are side views for explaining a method for cleaning the gas dischargers 31a to 31e by using the cleaner 34. To form a film on a wafer through CVD, reaction products are produced on the wafer and also on the gas discharge surfaces 32a to 32e of the gas distributor 30a where reaction gas passes. If the reaction products are left as they are, they are detached and attached on the wafer to interrupt patterning of films or cause abnormal deposition of films. Therefore, it is necessary to regularly clean the gas discharge surfaces 32a to 32e of the gas dischargers 31a to 31e.

To clean the gas discharge surfaces 32a to 32e of the gas dischargers 31a to 31e, the rotary shaft 27a is first moved upward to secure a space for moving the cleaner 34 between the wafer holder 21a and the gas dischargers 31a to 31e.

Thereafter, the cleaner 34 stored closely to the rotary shaft 27a is rotated clockwise around the rotary shaft 36 and moved onto the gas discharge surface 32d to make the cleaner 34 contact the surface 32d. Then, the cleaner 34 is reciprocated right and left around the rotary shaft 36 so as to cover the entire gas discharge surface 32d. Thereby, reaction products are physically and forcibly detached by the brush 35 and the detached reaction products are sucked by the cleaner 34 without diffusing and discharged to the outside of the CVD apparatus. Then, the cleaner 34 is moved by rotating the rotary shaft 27a to clean the gas discharge surface 32c in the same way as the above.

Subsequently, the another gas discharge surfaces 32b, 32a, and 32e are successively cleaned. In this case, because detached dust is immediately sucked by the cleaner, the inside of the CVD apparatus is kept clean without being contaminated.

As described above, the CVD apparatus of the first embodiment of the present invention makes it possible to apply electrical wiring to the heaters 28a to 28f without any special idea because the heaters 28a to 28f are separated from the rotary wafer holder 21a.

Moreover, because the wafers 24a to 24f can be moved on a plane put between the gas dischargers 31a to 31e and the heaters 28a to 28f according to the rotation of the wafer holder 21a, films can be formed continuously or intermittently and a high throughput can be obtained.

Though it is considered to combine the wafer holder 21a with the heaters 28a to 28f, the constitution of the present invention is more advantageous because the combination of the wafer holder with the heaters makes the structure including the electrical connection of wires with the rotating heaters 28a to 28f complex.

Moreover, because independent susceptors 22a to 22f and gas dischargers 31a to 31f are used, it is possible to accurately control production and continuously form different types of multilayer films.

Furthermore, because the wafer mounting surfaces 23a to 23f are made to perform reciprocative arc motion around an axis vertical to each mounting surface or reciprocative linear motion in the radial direction of a circle around the axis by osci llation units, reaction gas is uniformly supplied to wafers and therefore films with uniform thickness and quality can be formed on wafers.

For the first embodiment, the gas distributor 30a is arranged under the wafer holder 21a and the heaters 28a to 28f are arranged above it as shown in Fig. 8 (a). However, it is also possible to arrange the gas distributor 30e above the wafer holder 21e and the heaters under it as shown in Fig. 9 (a). In this case, the deposition surface of a wafer is turned upward.

For the first embodiment, a case is described in which the wafer mounting surfaces 23a to 23f are made to perform reciprocative arc motion around the axis vertical to each mounting surface or reciprocative linear motion in the radial direction of the circle around the axis by oscillation units. However, it is also possible to use oscillation units for making the surfaces perform reciprocative arc motion in the circumferential direction around the rotary shaft 27a or reciprocative linear motion in the radial direction around the rotary shaft 27a.

### (D) Film forming method

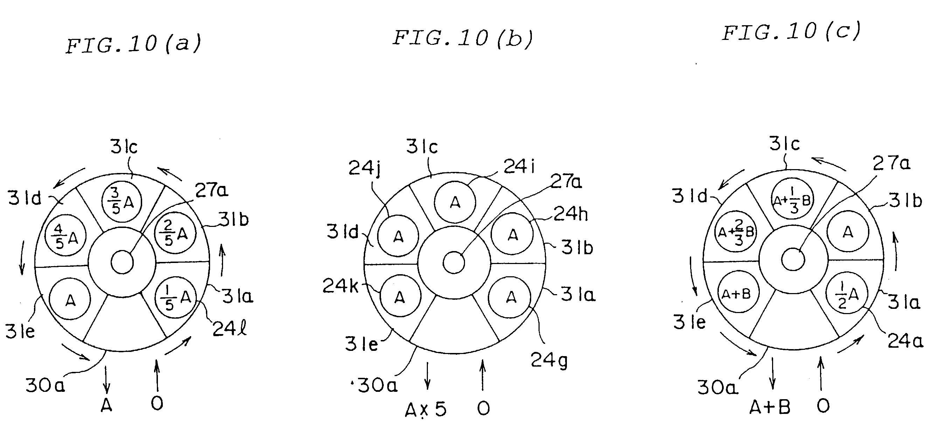

A method for forming a two-layer insulating film on a wafer by using the CVD apparatus shown in Fig. 1 is described below by referring to Figs. 1, 4, and 10 (c). In this case, as shown in Fig. 10 (c), a two-layer insulating film made of a CVD SiO₂ film and a PSG film with a predetermined thickness respectively is formed on the wafers 24a to 24f while the discrete wafer holder 21a makes a round of the rotary shaft 27a. In Fig. 10 (c), A shows a target thickness of the CVD SiO₂ film to be formed on the wafers 24a to 24f and B shows a target thickness of the PSG film.

First, the first wafer 24a is transferred from a cassette station to the susceptor 22a waiting at the loading/unloading portion 33a by the robot 38a. Then, when the first wafer 24a contacts the wafer mounting surface 23a of the susceptor 22a, a vacuum chuck is operated by a not-illustrated solenoid valve to exhaust gas through the exhaust port 25a and draw to secure the first wafer 24a to the wafer mounting surface 23a. In this case, electric power is supplied to all the heaters 28a to 28f to set the temperature of the wafer mounting surfaces 23a to 23f of all the susceptors 22a to 22f to approx. 350°C.

When the temperature of the first wafer 24a reaches the temperature of approx. 350°C, the rotary shaft 27a is rotated counterclockwise to stop the susceptor 22a at a position just above the gas distributor 31a. In this case, because the moving time is so short as to be approx. 0.8 sec and the susceptor 22a has a large heat capacity, the temperature of the first wafer 24a is hardly lowered during moving.

Then, TEOS-O₃ mixed gas is discharged from the gas discharger 31a as reaction gas. In this case, the deposition rate of an SiO₂ film is approx. 2,000 Å/min. By keeping this state for approx. 1 min, an SiO₂ film with the thickness of approx. 2,000 Å which is approx. 1/2 the target thickness of 4,000 Å is formed on the first wafer 24a. While the film is formed, the susceptor 22a is made to perform linear reciprocative motion around the held position by a not-illustrated oscillation unit.

Therefore, the reaction gas is uniformly supplied onto the first wafer 24a, whereby the thickness distribution of the formed SiO₂ film becomes more uniform and the quality of it becomes higher. In this period, the second wafer 24b is mounted on the susceptor 22b waiting at the loading/unloading portion 33a in the same way as the above and heated up to the temperature of approx. 350°C.

Then, the rotary shaft 27a is rotated to stop the susceptors 22b and 22a at positions just above the gas distributors 31a and 31b respectively. In this case, because the temperature of the second wafer 24b already reaches the temperature of approx. 350°C, it is possible to immediately start film forming. Therefore, by immediately discharging the TEOS-O₃ mixed gas from the gas dischargers 31a and 31b as reaction gas and keeping this state for approx. 1 min, an SiO₂ film with the thickness of approx. 2,000 Å which is approx. 1/2 the target thickness is formed on the second wafer 24b. In this period, the third wafer 24c is mounted on the susceptor 22c waiting at the loading/unloading portion 33a in the same way as the above and heated up to the temperature of approx. 350°C.

Then, the rotary shaft 27a is rotated to stop the susceptors 22c, 22b, and 22a just above the gas dischargers 31a, 31b, and 31c respectively. In this case, because the third wafer 24c already reaches the temperature of approx. 350°C, it is possible to immediately start film forming. Therefore, by immediately discharging TEOS-O₃ and TMPO mixed gas from the gas dischargers 31a, 31b, and 31c as reaction gas and keeping this state for approx. 1 min, a PSG film with the thickness of approx. 2,000 Å which is approx. 1/3 the target thickness is formed on the first wafer 24a, an SiO₂ film with the target thickness of approx. 4,000 Å is formed on the second wafer 24b, and moreover, an SiO₂ film with the thickness of approx. 2,000 Å which is approx. 1/2 the target thickness is formed on the third wafer 24c.

By setting wafers to the susceptors 22d to 22f to send them one by one according to the above way, a two-layer insulating film made of an SiO₂ film and a PSG film is formed on the wafers. When the first wafer 24a makes a round of the rotary shaft 27a and returns to the loading/unloading portion 33a again, targeted SiO₂ and PSG films are formed on the first wafer 24a. Because the wafer temperature is kept approximately constant in this period, the stability of the wafer temperature for film forming is very high.

Then, when the robot 38a is moved to the loading/unloading portion 33a, the solenoid valve is closed, and a not-illustrated nitrogen-gas introduction port valve is opened to send nitrogen gas to the vacuum chuck, the first wafer 24a detached from the wafer mounting surface 23a is held by the robot 38a.

Then, the robot 38a brings out the first wafer 24a to the cooling chamber 37c above the cassette station. The first wafer 24a brought out to the cooling chamber 37c is cooled by blowing nitrogen gas and thereafter stored in a wafer cassette. Thus, SiO₂ and PSG films with a predetermined thickness are successively formed and wafers are accumulated in the wafer cassette.

As described above, the SiO₂ film forming method using the CVD apparatus of the first embodiment makes it possible to obtain a high throughput because loading time and unloading time are not added explicitly.

Moreover, because the susceptors 22a to 22f and gas dischargers 31a to 31e are separately provided, it is possible to accurately control the production of each wafer.

Furthermore, each of the susceptors 22a to 22f is made to perform reciprocative linear motion on one plane around each position by each oscillation unit. Therefore, the reaction gas is uniformly supplied to wafers even if a supply of the gas fluctuates.

Moreover, because the wafer holder 21a has a large heat capacity and completes a movement for a short time, the wafer temperature is hardly lowered even while the wafer holder 21a moves. Therefore, the wafer temperature is kept almost constant and very stable. Thereby, it is possible to form a film with a uniform thickness distribution and a high quality on a wafer.

For the above semiconductor device manufacturing method, a two-layer insulating film is formed by using two types of reaction gases. However, as shown in Fig. 10 (a), it is also possible to form one type of film on the wafer 24i while the wafer 24i makes a round by flowing one type of reaction gas from the dischargers 31a to 31e.

Moreover, as shown in Fig. 10 (b), it is also possible to form similar to the batch process by previously setting wafers 24g to 24k to all the susceptors 22a to 22f and then simultaneously forming a film on the wafers 24g to 24k by using one type of reaction gas.

### (2) Second to fourth embodiments and sixth to eighth embodiments

### (A) Constitution of CVD apparatus

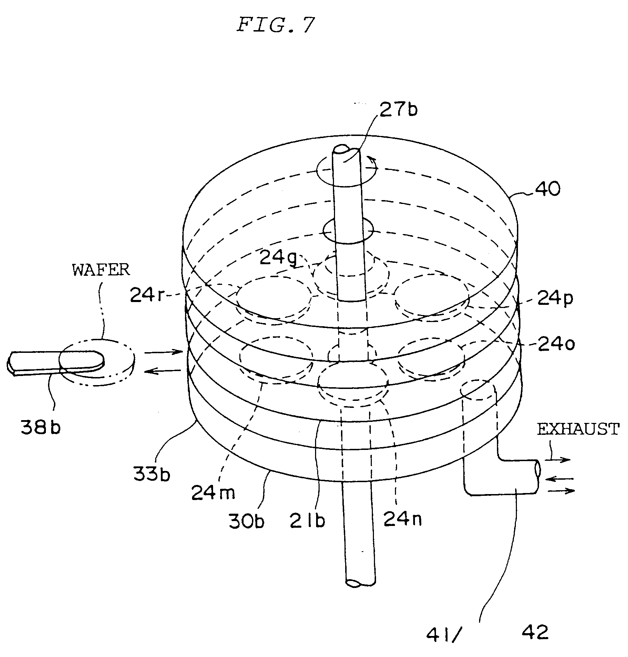

Fig. 7 is an illustration for explaining the constitution of the CVD apparatus of the second embodiment of the present invention. The constitution comprises a combination of the one-body gas distributor 30b with the one-body wafer holder 21b shown in Fig. 8 (b).

In Fig. 7, symbol 21b is a large-heat-capacity discoid wafer holder rotating around a rotary shaft 27b. The discoid surface around the rotary shaft 27b has wafer mounting surfaces capable of mounting a plurality of wafers with their faces downward. A discoid heating instrument 40 is provided at the upper side of the wafer holder 21b separately from the wafer holder 21b. Moreover, heaters are provided on the entire surface of the heating instrument 40 facing the wafer holder 21b so as to surround the rotary shaft 27b and wafers are indirectly heated when the temperature of the wafer holder 21b is raised by the heaters.

Symbol 30b is a discoid gas distributor settled to the base of the CVD apparatus, which is provided so as to face the wafer mounting surfaces of the wafer holder 21b. Radial slits around the rotary shaft 27b are formed as gas discharge portions at the side facing the wafer mounting surfaces of the gas distributor 30b and reaction gas introduced to a reaction gas introduction port 41 is discharged from the slits. Moreover, not-illustrated gas collectors are provided on the periphery of the gas discharge portions so as to surround them and collected extra gas is discharged out through an exhaust port 42.

Symbol 38b is a robot for mounting wafers on the wafer mounting surfaces of the wafer holder 21b or detaching them from the wafer mounting surfaces of it. As described above, the CVD apparatus of the second embodiment of the present invention makes it possible to obtain a high throughput because wafer loading time and unloading time are not added explicitly.

Moreover, because the heating instrument 40 is fixed, electric wires can be easily connected to the heating instrument 40 and therefore the structure of the apparatus is simplified.

Though the above second embodiment has faced-down-wafer mounting surfaces, the present invention can be also applied to the apparatus having faced-up-wafer mounting surfaces shown in Fig. 9 (b) as the sixth embodiment.

In addition to the combination of a gas distributor with a wafer holder described in the first and second embodiments, other combinations shown in the third, fourth, seventh, and eighth embodiments are also permitted. The combinations are shown in Figs. 8 (c), 9 (c), 8 (d), and 9 (d).

Fig. 8 (c) is the third embodiment showing the combination of a discrete wafer holder 21c with a one-boy gas distributor 30c, Fig. 8 (d) is the fourth holder 21d with a discrete gas distributor 30d, Fig. 9 (c) is the seventh embodiment showing the combination of a one-body gas distributor 30g with a discrete wafer holder 21g, and Fig. 9 (d) is the eighth embodiment showing the combination of a discrete gas distributor 30h with a one-body wafer holder 21h.

These embodiments make it possible to form films according to a method suitable for forming each type of film. In these figures, symbols 27c, 27g, 27d, and 27h are rotary shafts for rotating wafer holders.

For the above embodiments, the semiconductor device manufacturing apparatus of the present invention is applied to CVD apparatuses for forming films under the normal pressure. However, it can be also applied to CVD apparatuses for forming films under a low pressure by means of plasma CVD.

### (B) Film forming method

Then, a method for forming one type of CVD SiO₂ film on a wafer by using the CVD apparatus of the second embodiment by referring to Fig. 7. In this case, a plurality of wafers are previously mounted on the wafer holder 21b and one type of CVD SiO₂ film with a predetermined thickness is formed on each wafer while the wafer holder 21 makes a round of the rotary shaft 27b. That is, a film forming method similar to the batch processing shown in Fig. 10 (b) is executed. In Fig. 10 (b), symbol A shows the target thickness of the CVD SiO₂ film.

First, six wafers 24m to 24r are successively transferred to the loading/unloading portion 33b from the cassette station by the robot 38b, mounted on the wafer mounting surfaces of the wafer holder 21b, and secured to the mounting surfaces by the vacuum chuck respectively.

Then, electric power is supplied to heaters to produce heat. Thereby, the wafer holder 21b is heated by radiant heat and convection heat and the wafers 24m to 24r on the wafer mounting surfaces are also heated by 24r on the wafer mounting surfaces are also heated by conduction heat.

Then, after the temperature of the wafers 24m to 24r reaches approx. 350°C, TEOS-O₃ mixed gas is discharged from the gas discharge portion of the gas distributor 30b as reaction gas and the rotary shaft 27b is rotated at a speed in which the shaft makes a round in approx. 1 min while keeping the temperature of the wafers 24m to 24r at approx. 350°C. When the film forming rate is set to approx. 2,000 Å/min, a CVD SiO₂ film with the target thickness of 8,000 Å is uniformly formed on the wafers 24m to 24r after the rotary shaft 27b makes four rounds.

Then, after a supply of the reaction gas to the gas distributor 30b is stopped, the wafers 24m to 24r are successively detached from the wafer holder 21b by reversing the procedure for mounting the wafers 24m to 24r. That is, the solenoid valve of the exhaust port is closed to send nitrogen gas to the vacuum chuck by opening the valve at the nitrogen gas introduction port and the wafers 24m to 24r are detached from the wafer mounting surfaces to successively transfer them to the cassette station by the robot 38b.

Thus, a CVD SiO₂ film with a predetermined thickness can be formed on six wafers 24g to 24k at the same time.

As described above, the CVD SiO₂ film forming method using the CVD apparatus of the second embodiment makes it possible to easily operate and maintain the apparatus because only one reaction-gas supply pipe and only one system for supplying electric power to heaters are required though the throughput is limited because loading time and unloading time of wafers are necessary.

Moreover, because the wafer holder 21b is always heated even while it moves and has a large heat capacity though the heater 40 is separated from the wafer holder 21b, the wafer temperature is kept constant and therefore the temperature stability is high. Thereby, it is possible to form a film with a uniform thickness distribution and a high quality on a wafer.

For the above semiconductor device manufacturing method, film forming is performed by a method similar to the batch process shown in Fig. 10 (b) in which the wafers 24m to 24r are previously set to all wafer mounting surfaces of the wafer holder 21b and then a film is formed on the wafers 24m to 24r at the same time. However, as shown in Fig. 10 (a), it is also possible to successively set wafers to the wafer holder 21b and form a film with a predetermined thickness while the wafer 241 makes a round of the rotary shaft 27b.

## Claims

1. An apparatus for forming a film onto a wafer (24a to 24f) comprising:
a gas distributor (30a to 30h) discharging a reaction gas;
a heating instrument facing the gas distributor (30a to 30h); and
a wafer holder (21a to 21h) rotating, around a rotary shaft, between the gas distributor (30a to 30h) and the heating instrument,
**characterized in that**
said wafer holder (21a to 21h) has both a front surface for mounting said wafer (24a to 24f) and a back surface, said front surface facing the gas distributor (30a to 30h),
said back surface facing the heating instrument in proximity so that the heating instrument heats said wafer (24a to 24f) indirectly through said wafer holder (21a to 21h).

2. The apparatus for manufacturing a semiconductor device according to claim 1, wherein the wafer holder (21a) has a plurality of wafer mounting surfaces (23a) to (23f) along its circumference around the rotary shaft (27a).

3. The apparatus for manufacturing a semiconductor device according to claim 1 or 2, wherein the wafer holder (21a) comprises a plurality of independent susceptors (22a) to (22f), and wherein each susceptor (22a) to (22f) has a wafer mounting surface (23a) to (23f) along its circumference around the rotary shaft (27a) on the rotation plane.

4. The apparatus for manufacturing a semiconductor device according to claim 3, further comprising means for causing the wafer mounting surface (23a) to (23f) to perform a reciprocative arc motion around an axis vertical to the wafer mounting surface (23a) to (23f) or a reciprocative linear motion in the radial direction of a circle around the axis.

5. The apparatus for manufacturing a semiconductor device according to claim 1, further comprising means for causing the wafer mounting surface (23a) to (23f) to perform a reciprocative arc motion along its circumference around the rotary shaft (27a) or a reciprocative linear motion in the radial direction of a circle around the rotary shaft (27a).

6. The apparatus for manufacturing a semiconductor device according to claims 1 to 5, wherein the gas distributor (30a) has a plurality of independent gas dischargers (31a) to (31e), and wherein reaction gas is independently supplied to each gas discharger (31a) to (31e).

7. The apparatus for manufacturing a semiconductor device according to claim 6, wherein the heating instrument comprises a plurality of independent heaters (28a) to (28f).

## Patentansprüche

1. Vorrichtung zum Ausbilden eines Films auf einem Wafer (24a bis 24f), umfassend:
einen Gasverteiler (30a bis 30h), welcher ein Reaktionsgas freisetzt;
eine Heizeinrichtung, die auf den Gasverteiler (30a bis 30h) gerichtet ist; und
einen Waferhalter (21a bis 21h), der sich um eine Drehwelle herum und zwischen dem Gasverteiler (30a bis 30h) und der Heizeinrichtung dreht,
dadurch gekennzeichnet, daß
der Waferhalter (21a bis 21h) sowohl eine Vorderseite zum Halten des Wafers (24a bis 24f) und eine Rückseite aufweist, wobei die Vorderseite auf den Gasverteiler (30a bis 30h) gerichtet ist und wobei die Rückseite auf die Heizeinrichtung gerichtet ist und sich in der Nähe derselben befindet, so daß die Heizeinrichtung den Wafer (24a bis 24f) indirekt durch den Waferhalter (21a bis 21h) hindurch aufheizt.

2. Vorrichtung zum Herstellen einer Halbleitereinrichtung gemäß Anspruch 1, wobei der Waferhalter (21a) mehrere Waferhalteflächen (23a bis 23f) entlang seines Umfanges um die drehbare Welle (27a) herum aufweist.

3. Vorrichtung zum Herstellen einer Halbleitereinrichtung gemäß Anspruch 1 oder 2, wobei der Waferhalter (21a) mehrere voneinander unabhängige Halterungen (22a bis 22f) aufweist, und wobei jede Halterung (22a bis 22f) eine Waferhaltefläche (23a bis 23f) entlang ihres Umfanges um die drehbare Welle (27a) herum in der Drehebene aufweist.

4. Vorrichtung zum Herstellen einer Halbleitereinrichtung gemäß Anspruch 3, weiter umfassend Mittel, die die Waferhaltefläche (23a bis 23f) veranlassen, eine bogenförmige Hin- und Herbewegung um eine Achse vertikal zur Waferhaltefläche (23a bis 23f) oder eine lineare Hin- und Herbewegung in radialer Richtung eines Kreises um die Achse herum auszuführen.

5. Vorrichtung zum Herstellen einer Halbleitereinrichtung gemäß Anspruch 1, weiter umfassend Mittel, die die Waferhaltefläche (23a bis 23f) veranlassen, eine bogenförmige Hin- und Herbewegung entlang ihres Umfanges um die Drehwelle (27a) herum oder eine lineare Hin- und Herbewegung in radialer Richtung eines Kreises um die drehbare Welle (27a) herum auszuführen.

6. Vorrichtung zum Herstellen einer Halbleitereinrichtung gemäß den Ansprüchen 1 bis 5, wobei der Gasverteiler (30a) mehrere unabhängige Gasverteiler (31a bis 31e) aufweist und wobei das Reaktionsgas unabhängig durch jeden der Gasverteiler (31a bis 31e) zugeführt wird.

7. Vorrichtung zum Herstellen einer Halbleitereinrichtung gemäß Anspruch 6, wobei die Heizeinrichtung mehrere unabhängige Heizungen (28a bis 28f) umfaßt.

## Revendications

1. Appareil pour former un film sur une pastille (24a à 24f) comportant :
un distributeur de gaz (30a;...;30h) déchargeant un gaz de réaction,
un instrument de chauffage situé en vis à vis du distributeur de gaz (30a;...;30h), et
un support de pastille (21a;...;21h) tournant, autour d'un arbre rotatif, entre le distributeur de gaz (30a;...;30h) et l'instrument de chauffage,
caractérisé en ce que
ledit support de pastille (21a;...;21h) comporte à la fois une surface avant destinée au montage de ladite pastille (24a à 24f) et une surface arrière, ladite surface avant étant située en vis à vis du distributeur de gaz (30a;...;30h), ladite surface arrière étant située en vis-à-vis de l'instrument de chauffage à proximité de celui-ci, de sorte que l'instrument de chauffage chauffe ladite pastille (24a à 24f) indirectement à travers ledit support de pastille (21a;...;21h).

2. Appareil pour fabriquer un dispositif à semi-conducteur selon la revendication 1, dans lequel le support de pastille (21a) comporte plusieurs surfaces de montage de pastille (23a à 23f) agencées le long de sa circonférence autour de l'arbre rotatif (27a).

3. Appareil pour fabriquer un dispositif à semi-conducteur selon la revendication 1 ou 2, dans lequel le support de pastille (21a) comporte plusieurs suscepteurs indépendants (22a à 22f), et dans lequel chaque suscepteur (22a à 22f) a une surface de montage de pastille (23a à 23f) agencée le long de sa circonférence autour de l'arbre rotatif (27a) dans le plan de rotation.

4. Appareil pour fabriquer un dispositif à semi-conducteur selon la revendication 3, comportant en outre des moyens pour amener la surface de montage de pastille (23a à 23f) à effectuer un mouvement alternatif en arc de cercle autour d'un axe perpendiculaire à la surface de montage de pastille (23a à 23f) ou un mouvement linéaire alternatif dans la direction radiale d'un cercle situé autour de l'axe.

5. Appareil pour fabriquer un dispositif à semi-conducteur selon la revendication 1, comportant en outre des moyens pour amener la surface de montage de pastille (23a à 23f) à effectuer un mouvement alternatif en arc de cercle le long de sa circonférence autour de l'arbre rotatif (27a) ou un mouvement linéaire alternatif dans la direction radiale d'un cercle situé autour de l'arbre rotatif (27a).

6. Appareil pour fabriquer un dispositif à semi-conducteur selon l'une quelconque des revendications 1 à 5 dans lequel le distributeur de gaz (30a) comporte plusieurs déchargeurs de gaz indépendants (31a à 31e), et dans lequel le gaz de réaction est alimenté de manière indépendante vers chaque déchargeur de gaz (31a à 31e).

7. Appareil pour fabriquer un dispositif à semi-conducteur selon la revendication 6, dans lequel l'instrument de chauffage comporte plusieurs éléments de chauffage indépendants (28a à 28f).
